# EUROPEAN PATENT SPECIFICATION

(11) **EP 1 333 329 B1**
(45) Date of publication and mention of the grant of the patent: **02.07.2008**
(21) Application number: 03250567.9
(22) Date of filing: 30.01.2003
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 01.02.2002 EP 02250707
(43) Date of publication of application: 06.08.2003
(73) Proprietor: ASML Netherlands B.V., 5504 DR Veldhoven (NL)
(72) Inventor: Mertens, Jeroen Johannes Sophia Maria, 5525 BC Duizel (NL)
(74) Representative: Leeming, John Gerard

(56) References cited:
- EP-A- 1 098 225
- EP-A- 1 098 226
- EP-A- 1 256 847
- WO-A-01/06548
- US-A- 4 989 031
- US-A- 2001 035 942
- PATENT ABSTRACTS OF JAPAN vol. 2002, no. 04, 4 August 2002 (2002-08-04) -& JP 2001 358056 A (CANON INC), 26 December 2001 (2001-12-26) -& US 2002/018190 A1 (NOGAWA HIDEKI ET AL) 14 February 2002 (2002-02-14)
- PATENT ABSTRACTS OF JAPAN vol. 015, no. 280 (E-1090), 16 July 1991 (1991-07-16) -& JP 03 097216 A (HITACHI LTD), 23 April 1991 (1991-04-23)

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a first compartment with a contaminant sensitive component within it; and
- first gas supply means arranged to purge the interior of the first compartment with a first purge gas.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g*. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

The key optical elements of the apparatus described above, such as the projection lens for example, must be kept free of contaminants such as oxygen, moisture and hydrocarbons. Sources of contaminants include the ambient environment around the apparatus, components such as actuators within the apparatus, the resist, the radiation source and the mask. The contaminants may absorb the radiation leading to unacceptable losses and/or local variations in beam intensity. It is necessary therefore to ensure that the ingress of external contaminants to compartments containing contaminant sensitive components is minimized and that the penetration of contaminants, generated in proximity to or within these compartments, to such contaminant sensitive components is also minimized.

JP 03-097 216 A discloses a lithographic apparatus including a first gas purged chamber within a second chamber and a system for gas purging the space between the first and second chambers.

US 2001/0035942 discloses a lithographic apparatus having a projection system within a chamber in which the pressure in the chamber is reduced and high purity gas is then supplied to the chamber. The chamber is surrounded by a second compartment in which the pressure may also be reduced before high purity gas is supplied to the compartment.

It is an object of the present invention to reduce the level of external contaminants reaching optical components and to remove internally generated contaminants.

This and other objects are achieved according to the invention in a lithographic apparatus as specified in the opening paragraph, further comprising:
- a second compartment surrounding the first compartment;
- second gas supply means arranged to supply a flow of second purge gas to the exterior surface of the enclosure defining the first compartment and to purge the space between the first and second compartments;
- an opening in said second compartment; and
- a link passing through the opening;
wherein said link provides a mechanical connection between the first compartment and a component located outside the second compartment;
characterized in that the second compartment further comprises a gas outlet on one side of said opening and a gas extractor on an opposite side of the opening, arranged such that the opening can be covered with a gas curtain.

This apparatus is advantageous since the purging of the exterior surface of the compartment removes much of the contaminants generated around the compartment and reduces the ingress of external contaminants to the component located within the compartment. Any leakage into the compartment will be mainly the clean purge gas. Purging the exterior surface of the compartment with a second flow of gas ensures that the contaminant level within the compartment is even lower than in the region immediately surrounding the compartment and consequently very low. The enclosure of the second compartment provides an additional barrier to the ingress of external contaminants, further reducing the level of contaminants within the first compartment. Furthermore, by providing a defined space that requires purging, the amount of purge gas required is significantly reduced and the purge gas is prevented from interfering with other components outside the second compartment. The link is advantageous as it allows a mechanical connection and other utilities and controls to be provided to the first compartment without substantially increasing the contaminant level in the compartment.

Advantageously, the second compartment may have an interface shield surrounding the opening and projecting into a second portion of the apparatus, external to the second compartment. This reduces the contaminant level within the second compartment by increasing the distance that contaminants must diffuse to pass through the opening. Consequently the contaminant level within the first compartment is also reduced.

In a further preferred aspect of the present invention, a seal is provided between the interface shield mounted on the second compartment and the link passing through the opening. This is beneficial since it reduces still further the ingress of contaminants from the second portion of the apparatus to the interior of the second compartment.

According to the disclosure, the external surface of the first compartment is purged by a curtain of purge gas or by a plurality of jets of purge gas directed at the external surface of the compartment.

According to yet another aspect of the present invention the first compartment comprises an outlet exhausting the first purge gas after having purged the interior of the first compartment, said outlet generating an additional flow of purge gas to the exterior surface of the enclosure defining the first compartment. This outlet may or may not be connected to gas mixing means for mixing the first purge gas exhausted from the first compartment with the second purge gas and for supplying the gas mixture to the exterior surface of the enclosure defining the first compartment. By re-using the first purge gas the amount of purge gas required is even more reduced.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;
- providing a first flow of purge gas to purge the interior of a first compartment containing a contaminant sensitive component of the device manufacturing apparatus; and
- providing a second flow of purge gas to the exterior surface of the enclosure defining said compartment in order to purge a space between said surface and a second compartment surrounding the first compartment;
- providing a link through an opening in said second compartment; and
- using said link to provide a mechanical connection between the first compartment and a component located outside the second compartment;
characterized by providing gas from a gas outlet on one side of said opening and extracting gas from a gas extractor on an opposite side of the opening, thereby covering the opening with a gas curtain.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus;
Figure 2 depicts a compartment in which the ingress of external contaminants is reduced and internal contaminants are removed;
Figure 3 depicts a compartment with a link to a component outside a second compartment encompassing the first compartment in which the ingress of external contaminants is reduced and internal contaminants are removed;
Figure 4 depicts a variation of the component of Figure 3; and
Figure 5 depicts a further variation of the component of Figure 3;
Figure 6 depicts an alternative compartment in which the ingress of external contaminants is reduced and internal contaminants are removed.

In the Figures, corresponding reference symbols indicate corresponding parts.

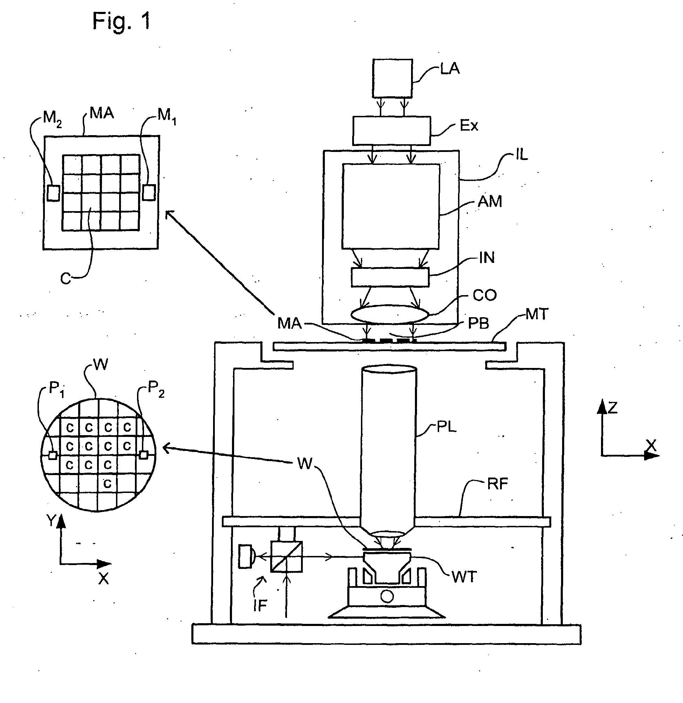

Figure 1 schematically depicts a lithographic projection apparatus . The apparatus comprises:
· a radiation system Ex, IL, for supplying a projection beam PB of radiation (*e.g.* UV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive or catadiotropic system or a mirror group) for imaging an irradiated portion of the mask MA onto a target portion C (*e.g.* comprising one or more dies) of the substrate W.
As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g*. so as to position different target portions C in the path of the beam PB. Similarly, the first positioning means can be used to accurately position the mask MA with respect to the path of the beam PB, *e.g*. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed ν, so that the projection beam PB is caused to scan over a mask image; concurrently, the substrate table WT is simultaneously moved in the same or opposite direction at a speed *V = M*ν, in which *M* is the magnification of the lens PL (typically, *M* = 1/4 or 1/5). In this manner, a relatively large target portion C can be exposed, without having to compromise on resolution.

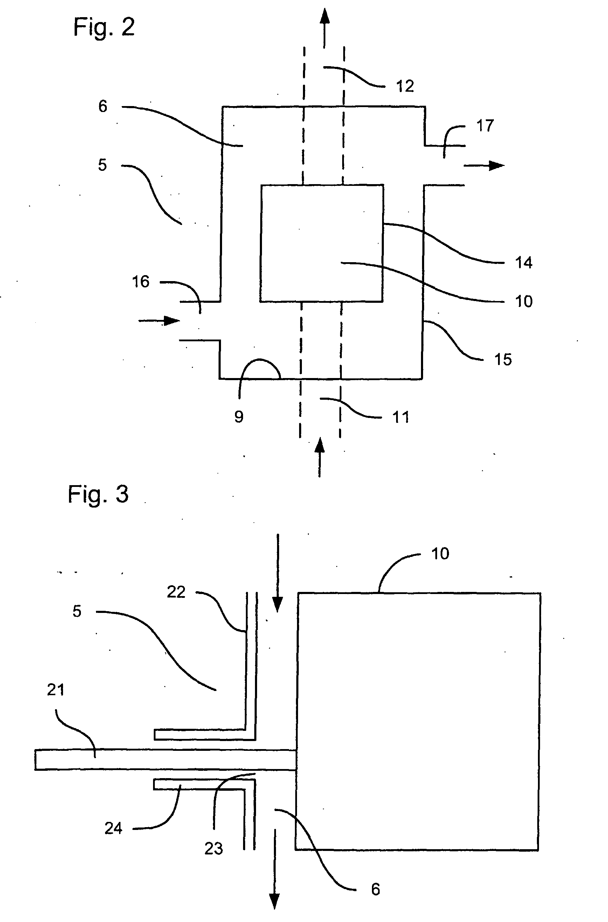

Figure 2 shows a compartment 10 of the apparatus, containing a component that is sensitive to contaminants. Such a component may be, for example, the projection system, the illumination system or a component (e.g. an optical element) within the projection system or illumination system. The first compartment 10 is located in a second compartment 9, defined by a barrier 15. The space between an enclosure 14 defining the first compartment 10 and the barrier 15 of the second compartment 9 defines a first portion 6 of the apparatus outside the first compartment.
The barrier 15 separates the first portion 6 of the apparatus from a second portion 5 of the apparatus. Depending on the component to be screened from contaminants, the first and second portions 6, 5 may, for example, be both located in the projection system or, for example, the first compartment may be the projection system or some other component. Similarly either one of the compartments may be the Projection Optics Box (POB) which houses the projection system.

The inside of the first compartment 10 is purged by a flow of gas provided through an inlet 11 and exhausted through an outlet 12. Separately, the external surface of the first compartment 10 is purged by a flow of gas provided through an inlet 16 and exhausted through an outlet 17. The combination of the barrier 15 and the flow of gas through the first portion 6 of the apparatus ensures that the contaminant level in the first portion 6 of the apparatus (i.e. within the second compartment) is significantly lower than that in the second portion of the apparatus 5. Contaminants external to the first portion 6 of the apparatus (such as contaminants from the external environment of the apparatus and from components located in the second portion 5 of the apparatus) are restricted from passing through the barrier 15. Contaminants that do leak through the barrier 15 and those generated within the first portion 6 of the apparatus are flushed out by the purge gas through the outlet 17. However, the required maximum contamination level in the optical component may be lower than that attainable in the first portion 6 of the apparatus. Therefore the component is contained within the enclosure 14 that defines the first compartment 10. This enclosure prevents or significantly reduces the ingress of contaminants from the first portion 6 of the apparatus to the inside of compartment 10 and thence to the optical component. Furthermore any contaminants that do leak through the enclosure 14 and any contaminants generated within the first compartment 10 are flushed out by the purge gas through the outlet 12.

The purge gas used to flush both the first compartment 10 and the second compartment 9 are preferably transparent to the radiation used. Suitable examples of gases that may be used are gases from the group comprising N₂, He, Ar, Kr, Ne, Xe or a mixture of two or more of these. In an exemplary embodiment of the present invention, the inside of the first compartment 10 is purged with He gas and the outside of the first compartment 10, namely the first portion 6 of the apparatus, is purged with N₂ gas. In any case, the oxygen and water vapor content of the gases used for purging should be minimized and preferably substantially zero. A suitable limit for the water vapor content is less than 0.5 ppm and a suitable limit for the oxygen content is less than 1 ppm.

The contaminant fraction (i.e. the proportion of contaminants within the gas) must be lower in the purge gas used to purge the inside of the first compartment than in the purge gas used to purge the outside of the first compartment. However the lower the required contaminant fraction of a purge gas, the greater the cost of producing it. Consequently it is desirable to minimize the use of the cleanest purge gas, i.e. that suitable for use in purging the inside of the first compartment. Preferably, therefore, the purge gas supplies for purging the interior and the exterior of the first compartment 10 are separate. However in some circumstances it may be preferable to minimize the complexity of the apparatus. In such circumstances the purge gas supply for purging the inside and the outside of the first compartment 10 may be combined. In any case, the contaminant fraction of both purge gases will be lower than the contaminant fraction of the air in the ambient environment surrounding the second compartment.

As the requirements for purging the exterior of the first compartment 10 are less stringent than those for purging the interior, it may be envisaged to re-use the first purge gas exhausted through outlet 12 in purging the exterior of said first compartment. To this end the outlet 12 may be connected to gas mixing means (not shown) for mixing the first purge gas exhausted from the first compartment 10 with the second purge gas and for supplying the gas mixture to the exterior of the first compartment 10, or the said first purge gas may be supplied directly to the exterior of the first compartment 10.

The first compartment 10 typically requires a link between itself and a part of the apparatus located within the second portion of the apparatus. Figure 3 shows a means of providing such a link whilst minimizing the ingress of contaminants to the first portion 6 of the apparatus. The first compartment 10 is located within the first portion 6 of the apparatus and separated from the second portion 5 of the apparatus by a barrier 22. As described above, both the first compartment 10 and the first portion 6 of the apparatus are purged by a flow of gas.

The barrier 22 has an opening 23 through which a link 21 passes to connect the first compartment 10 to a component of the apparatus (not shown) in the second portion 5 of the apparatus. The link provides a mechanical connection, for example to provide a means for positioning the first compartment 10 using an actuator located in the second portion 5 of the apparatus.

Preferably, as shown in Figure 3, the barrier 22 has a an interface shield 24 surrounding the opening 23 and extending into the second portion 5 of the apparatus. The interface shield 24 increases the distance that any contaminants must diffuse to pass from the second portion 5 of the apparatus to the first portion 6 of the apparatus, thereby reducing the level of contamination in the first portion. It may be substantially cylindrical.

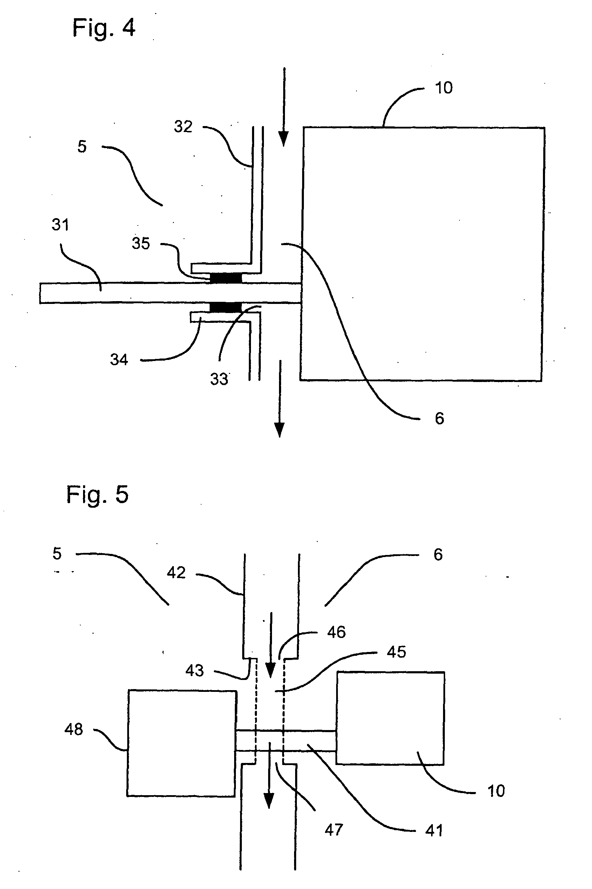

Figure 4 shows a variation of the arrangement described above in relation to Figure 3. The first compartment 10, located in the first portion 6 of the apparatus, is linked to the second portion 5 of the apparatus by means of a link 31 that passes through an opening 33 in barrier 32 which separates the first and second portions of the apparatus. In this case a seal 35 is provided between the link 31 and the interface shield 34. The seal further reduces the leakage of the contaminants from the second portion 5 of the apparatus into the first portion 6 of the apparatus. It is important that the seal 35 is made of a soft rubber having a low stiffness, such as celrubber, or a rubber with similar stiffness to reduce the transmission of vibrations between the components of the apparatus.

In addition to reducing the ingress of contaminants to the first portion 6 of the apparatus, the use of the seal will reduce the outflow of purge gas from the first portion 6 of the apparatus to the second portion of the apparatus. This may be important, for example, if the purge gas used for the first portion 6 of the apparatus is N₂ gas as this can interfere with the performance of interferometers located in the second portion 5 of the apparatus.

Figure 5 shows a further variation of the arrangements described above in relation to Figures 3 and 4. This arrangement may be especially useful if the required travel, perpendicular to the barrier, of the link is relatively large. The first compartment 10, located in the first portion 6 of the apparatus, is linked to a component 48 of the apparatus located in the second portion 5 of the apparatus. The barrier 42, separating the first and second portions of the apparatus has an opening 43 through which the link 41 passes. The opening 43 is covered by a curtain of purge gas. The curtain of purge gas is provided by an outlet 46 on one side of the opening 43 and extracted through an outlet 47 on an opposite side of the opening. The curtain of purge gas substantially reduces the contamination that diffuses through the opening. The gas curtain may be provided either in addition to the gas used to purge the first portion 6 of the apparatus or may be part of the means to purge the first portion 6 of the apparatus.

It should be appreciated that apparatus of the type described above will be operated in a clean room environment. Such a clean room should not be regarded as a second compartment as described above nor should any airflow within such a room be regarded as the second supply of purge gas. The air in such clean rooms contains oxygen and water vapor and is therefore not suitable as a purging gas in the context of the present application.

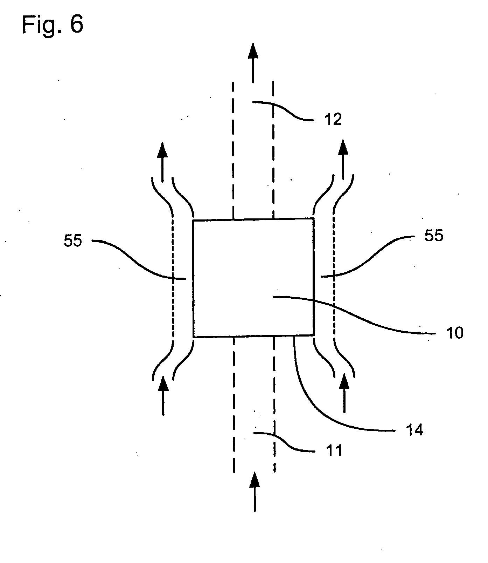

In Figure 6, the external surface of the first compartment 10 is purged using curtains 55 of purge gas (only two shown). In this case a second compartment, defining a portion of the apparatus that is flushed is not required. As before, the inside of the first component 10 is purged. In an alternative of this embodiment of the invention, the external surface of the first compartment is purged by a plurality of jets of purge gas directed at its external surface.

Whilst specific embodiments of the invention have been described above, it will be appreciated that the invention may be practiced otherwise than as described. The description is not intended to limit the invention which is defined by the claims.

## Claims

1. A lithographic projection apparatus comprising:
- a radiation system (Ex,IL) for providing a projection beam of radiation;
- a support structure (MT) for supporting patterning means (MA), the patterning means serving to pattern the projection beam according to a desired pattern;
- a substrate table (WT) for holding a substrate (W);
- a projection system (PL) for projecting the patterned beam (PB) onto a target portion (C) of the substrate;
- a first compartment (10) with a contaminant sensitive component within it;
- first gas supply means arranged to purge the interior of the first compartment with a first purge gas;
- a second compartment (9) surrounding the first compartment;
- second gas supply means arranged to supply a flow of second purge gas to the exterior surface of the enclosure defining the first compartment and to purge the space between the first and second compartments;
- an opening (43) in said second compartment (9); and
- a link (41) passing through the opening;
wherein said link provides a mechanical connection between the first compartment (10) and a component (48) located outside the second compartment;
**characterized in that** the second compartment (9) further comprises a gas outlet (46) on one side of said opening (43) and a gas extractor (47) on an opposite side of the opening, arranged such that the opening can be covered with a gas curtain (45).

2. A lithographic projection apparatus according to claim 1, wherein the second purge gas has a lower contaminant fraction than the air surrounding the first compartment.

3. A lithographic projection apparatus according to claim 1 or 2, wherein said first compartment at least partially surrounds the projection system.

4. A lithographic projection apparatus according to claim 1, 2 or 3, wherein said second compartment further comprises an interface shield (24), surrounding said opening (23) and extending from the second compartment (9).

5. A lithographic projection apparatus according to claim 4, further comprising a seal (35) between the link (31) and the interface shield (34).

6. A lithographic projection apparatus according to any preceding claim, wherein said second gas supply means provides a curtain of purge gas (55) across at least one face of the first compartment (10).

7. A lithographic projection apparatus according to any preceding claim, wherein said second gas supply means provides a plurality of outlets for purge gas close to at least one face of the first compartment (10).

8. A lithographic projection apparatus according to any preceding claim, wherein the first compartment (10) comprises an outlet (12) exhausting the first purge gas after having purged the interior of the first compartment, said outlet generating an additional flow of purge gas to the exterior surface of the enclosure defining the first compartment.

9. A lithographic projection apparatus according to claim 8, wherein the outlet (12) is connected to gas mixing means for mixing the first purge gas exhausted from the first compartment (10) with the second purge gas and for supplying the gas mixture to the exterior surface of the enclosure (14) defining the first compartment.

10. A lithographic projection apparatus according to any preceding claim, wherein the first or second gas supply means supplies a gas from the group comprising N₂, He, Ar, Kr, Ne, Xe or a mixture of two or more of these.

11. A device manufacturing method comprising the steps of:
- providing a substrate (W) that is at least partially covered by a layer of radiation-sensitive material;
- providing a projection beam of radiation using a radiation system (Ex, 1L);
- using patterning means (MA) to endow the projection beam with a pattern in its cross-section;
- projecting the patterned beam (PB) of radiation onto a target portion (C) of the layer of radiation-sensitive material;
- providing a first flow of purge gas to purge the interior of a first compartment (10) containing a contaminant sensitive component of the device manufacturing apparatus; and
- providing a second flow of purge gas to the exterior surface of the enclosure defining said compartment in order to purge a space between said surface and a second compartment (9) surrounding the first compartment;
- providing a link (41) through an opening (43) in said second compartment (9);
and
- using said link to provide a mechanical connection between the first compartment (10) and a component located outside the second compartment;
**characterized by** providing gas from a gas outlet (46) on one side of said opening (43) and extracting gas from a gas extractor (47) on an opposite side of the opening, thereby covering the opening with a gas curtain (45).

## Patentansprüche

1. Lithographische Projektionsvorrichtung, umfassend:
- ein Strahlungssystem (Ex, IL) zum Bereitstellen eines Projektionsstrahls aus Strahlung;
- einen Halteraufbau (MT) zum Halten einer Musteraufbringungseinrichtung (MA), wobei die Musteraufbringungseinrichtung dazu dient, den Projektionsstrahl mit einem erwünschten Muster zu mustern;
- einen Substrattisch (WT) zum Halten eines Substrats (W);
- ein Projektionssystem (PL) zum Projizieren des gemusterten Strahls (PB) auf einen Zielabschnitt (C) des Substrats;
- eine erste Kammer (10) mit einer darin enthaltenen kontaminantempfindlichen Komponente;
- eine erste Gaszufuhreinrichtung, die zum Spülen des Innenraums der ersten Kammer mit einem ersten Spülgas angeordnet ist;
- eine zweite Kammer (9), die die erste Kammer umgibt;
- eine zweite Gaszufuhreinrichtung, die zum Zuführen eines Flusses aus einem zweiten Spülgas zu der Außenoberfläche des Einschlusses, der die erste Kammer festlegt, und zum Spülen des Raumes zwischen der ersten und der zweiten Kammer angeordnet ist;
- eine Öffnung (43) in der zweiten Kammer (9); und
- ein Verbindungsglied (41), das durch die Öffnung verläuft;
wobei das Verbindungsglied eine mechanische Verbindung zwischen der ersten Kammer (10) und einer außerhalb der zweiten Kammer befindlichen Komponente (48) vorsieht;
**dadurch gekennzeichnet, dass** die zweite Kammer (9) ferner einen Gasauslass (46) an einer Seite der Öffnung (43) sowie einen Gasextraktor (47) an einer gegenüberliegenden Seite der Öffnung aufweist, die derart angeordnet sind; dass die Öffnung mit einem Gasvorhang (45) bedeckt werden kann.

2. Lithographische Projektionsvorrichtung nach Anspruch 1, bei der das zweite Spülgas einen geringeren Kontaminantanteil als die Luft besitzt, welche die erste Kammer umgibt.

3. Lithographische Projektionsvorrichtung nach Anspruch 1 oder 2, bei der die erste Kammer zumindest teilweise das Projektionssystem umgibt.

4. Lithographische Projektionsvorrichtung nach Anspruch 1, 2 oder 3, bei der die zweite Kammer ferner ein Grenzflächenschild (24) aufweist, das die Öffnung (23) umgibt und sich von der zweiten Kammer (9) erstreckt.

5. Lithographische Projektionsvorrichtung nach Anspruch 4, ferner umfassend eine Dichtung (35) zwischen dem Verbindungsglied (31) und dem Grenzflächenschild (34).

6. Lithographische Projektionsvorrichtung nach einem der vorhergehenden Ansprüche, bei der die zweite Gaszufuhreinrichtung einen Vorhang aus Spülgas (55) über zumindest eine Fläche der ersten Kammer (10) vorsieht.

7. Lithographische Projektionsvorrichtung nach einem der vorhergehenden Ansprüche, bei der die zweite Gaszufuhreinrichtung eine Vielzahl von Auslässen für Spülgas vorsieht, das sich in der Nähe von zumindest einer Fläche der ersten Kammer (10) befinden.

8. Lithographische Projektionsvorrichtung nach einem der vorhergehenden Ansprüche, bei der die erste Kammer (10) einen Auslass (12) aufweist, der das erste Spülgas nach dem Spülen des Innenraums der ersten Kammer ausströmen lässt, und bei der der Auslass einen zusätzlichen Fluss an Spülgas zur Außenoberfläche des Einschlusses erzeugt, der die erste Kammer festlegt.

9. Lithographische Projektionsvorrichtung nach Anspruch 8, bei der der Auslass (12) mit einer Gasmischeinrichtung verbunden ist zum Mischen des ersten Spülgases, das aus der ersten Kammer (10) ausströmt, mit dem zweiten Spülgas und zum Zuführen des Gasgemisches zu der Außenoberfläche des Einschlusses (14), der die erste Kammer festlegt.

10. Lithographische Projektionsvorrichtung nach einem der vorhergehenden Ansprüche, bei der die erste oder die zweite Gaszufuhreinrichtung ein Gas aus der Gruppe umfassend N₂, He, Ar, Kr, Ne, Xe oder ein Gemisch von zwei oder mehr derselben zuführt.

11. Verfahren zum Herstellen eines Bauteils, umfassend die Schritte:
- Bereitstellen eines Substrats (W), das zumindest teilweise mit einer Schicht aus einem strahlungsempfindlichen Material überzogen ist;
- Bereitstellen eines Projektionsstrahls aus Strahlung unter Verwendung eines Strahlungssystems (Ex, IL);
- Verwenden einer Musteraufbringungseinrichtung (MA), um den Querschnitt des Projektionsstrahls mit einem Muster zu versehen;
- Projizieren des gemusterten Strahls (PB) aus Strahlung auf einen Zielabschnitt (C) der Schicht aus strahlungsempfindlichen Material;
- Bereitstellen eines ersten Flusses an Spülgas, um den Innenraum einer ersten Kammer (10) zu spülen, die eine kontaminantempfindliche Komponente der Vorrichtung zur Herstellung des Bauteils enthält; und
- Bereitstellen eines zweiten Flusses an Spülgas zu der Außenoberfläche des Einschlusses, der die Kammer festlegt, um einen Raum zwischen der Oberfläche und einer zweiten Kammer (9), die die erste Kammer umgibt, zu spülen;
- Bereitstellen eines Verbindungsgliedes (41) durch eine Öffnung (43) in der zweiten Kammer (9); und
- Verwenden des Verbindungsgliedes, um eine mechanische Verbindung zwischen der ersten Kammer (10) und einer außerhalb der zweiten Kammer befindlichen Komponente vorzusehen;
**gekennzeichnet durch** das Bereitstellen von Gas aus einem Gasauslass (46) an einer Seite der Öffnung (43) und das Extrahieren von Gas aus einem Gasextraktor (47) an einer gegenüberliegenden Seite der Öffnung, um **dadurch** die Öffnung mit einem Gasvorhang (45) zu bedecken.

## Revendications

1. Appareil de projection lithographique, comprenant :
- un système de rayonnement (Ex, IL) pour délivrer un faisceau de projection de rayonnement;
- une structure de support (MT) pour supporter des moyens de mise en forme (MA), les moyens de mise en forme servant à mettre en forme le faisceau de projection selon un modèle voulu ;
- une table à substrat (WT) pour maintenir un substrat (W) ;
- un système de projection (PL) pour projeter le faisceau mis en forme (PB) sur une partie cible (C) du substrat ;
- un premier compartiment (10) avec un composant sensible aux contaminants à l'intérieur de celui-ci ;
- de premiers moyens de fourniture de gaz agencés pour purger l'intérieur du premier compartiment avec un premier gaz de purge ;
- un second compartiment (9) entourant le premier compartiment ;
- de seconds moyens de fourniture de gaz agencés pour fournir un flux de second gaz de purge sur la surface extérieure de l'enceinte définissant le premier compartiment et pour purger l'espace entre le premier et le second compartiment ;
- une ouverture (43) dans ledit second compartiment (9) ; et
- une liaison (41) passant à travers l'ouverture ;
dans lequel ladite liaison fournit une connexion mécanique entre le premier compartiment (10) et un composant (48) positionné à l'extérieur du second compartiment ;
**caractérisé en ce que** le second compartiment (9) comprend en outre une sortie de gaz (46) sur un côté de ladite ouverture (43) et un extracteur de gaz (47) sur un côté opposé de l'ouverture, agencés de sorte que l'ouverture puisse être couverte par un rideau de gaz (45).

2. Appareil de projection lithographique selon la revendication 1, dans lequel le second gaz de purge présente une fraction de contaminants inférieure à celle de l'air entourant le premier compartiment.

3. Appareil de projection lithographique selon la revendication 1 ou 2, dans lequel ledit premier compartiment entoure au moins partiellement le système de projection.

4. Appareil de projection lithographique selon la revendication 1, 2 ou 3, dans lequel ledit second compartiment comprend en outre un bouclier d'interface (24), entourant ladite ouverture (23) et s'étendant depuis le second compartiment (9).

5. Appareil de projection lithographique selon la revendication 4, comprenant en outre un joint (35) entre la liaison (31) et le bouclier d'interface (34).

6. Appareil de projection lithographique selon l'une quelconque des revendications précédentes, dans lequel lesdits seconds moyens de fourniture de gaz fournissent un rideau de gaz de purge (55) à travers au moins une face du premier compartiment (10).

7. Appareil de projection lithographique selon l'une quelconque des revendications précédentes, dans lequel lesdits seconds moyens de fourniture de gaz fournissent une pluralité de sorties pour du gaz de purge à proximité d'au moins une face du premier compartiment (10).

8. Appareil de projection lithographique selon l'une quelconque des revendications précédentes, dans lequel le premier compartiment (10) comprend une sortie (12) qui évacue le premier gaz de purge après qu'il a purgé l'intérieur du premier compartiment, ladite sortie générant un flux supplémentaire de gaz de purge vers la surface extérieure de l'enceinte définissant le premier compartiment.

9. Appareil de projection lithographique selon la revendication 8, dans lequel la sortie (12) est reliée à des moyens de mélange de gaz pour mélanger le gaz de purge évacué depuis le premier compartiment (10) au second gaz de purge, et pour amener le mélange gazeux à la surface extérieure de l'enceinte (14) définissant le premier compartiment.

10. Appareil de projection lithographique selon l'une quelconque des revendications précédentes, dans lequel les premiers ou les seconds moyens de fourniture de gaz fournissent un gaz choisi dans le groupe comprenant les éléments suivants : N₂, He, Ar, Kr, Ne, Xe ou un mélange de deux ou plusieurs de ceux-ci.

11. Procédé de fabrication de dispositif, comprenant les étapes de :
- fournir un substrat (W) qui est au moins partiellement recouvert par une couche de matériau sensible au rayonnement ;
- fournir un faisceau de projection de rayonnement en utilisant un système de rayonnement (Ex, 1L) ;
- utiliser des moyens de mise en forme (MA) pour doter le faisceau de projection d'un motif dans sa coupe transversale ;
- projeter le faisceau de rayonnement (PB) mis en forme sur une partie cible (C) de la couche de matériau sensible au rayonnement ;
- fournir un premier flux de gaz de purge pour purger l'intérieur d'un premier compartiment (10) contenant un composant sensible aux contaminants de l'appareil de fabrication de dispositif ; et
- fournir un second flux de gaz de purge sur la surface extérieure de l'enceinte définissant ledit compartiment afin de purger un espace entre ladite surface et un second compartiment (9) entourant le premier compartiment ;
- apporter une liaison (41) à travers une ouverture (43) dans ledit second compartiment (9) ;
et
- utiliser ladite liaison pour apporter une connexion mécanique entre le premier compartiment (10) et un composant situé à l'extérieur du second compartiment ;
**caractérisé par** la fourniture de gaz depuis une sortie de gaz (46) sur un côté de ladite ouverture (43) et par l'extraction de gaz par un extracteur de gaz (47) sur un côté opposé de l'ouverture, couvrant ainsi l'ouverture d'un rideau de gaz (45).
